# EUROPÄISCHE PATENTSCHRIFT

(11) **EP 2 084 812 B1**
(45) Veröffentlichungstag und Bekanntmachung des Hinweises auf die Patenterteilung: **04.01.2012**
(21) Anmeldenummer: 07849068.7
(22) Anmeldetag: 15.10.2007
(51) Int. Cl.: H03F 3/45

(54) **VERSTARKERSCHALTUNG**
AMPLIFIER CIRCUIT
CIRCUIT D'AMPLIFICATEUR

(30) Priorität: 26.10.2006 EP 06122966
(43) Veröffentlichungstag der Anmeldung: 05.08.2009
(73) Patentinhaber: NXP B.V., 5656 AG Eindhoven (NL)
(72) Erfinder: DICK, Burkhard, 1102 Vienna (AT)
(74) Vertreter: Krott, Michel
(86) Internationale Anmeldenummer: PCT/IB2007/054189
(87) Internationale Veröffentlichungsnummer: WO 2008/050259

(56) Entgegenhaltungen:
- EP-A- 0 893 880
- WO-A-03/005566
- DE-A1- 19 736 900
- US-A1- 2001 004 219

## Beschreibung

### Technisches Gebiet

Die Erfindung betrifft eine Verstärkerschaltung, insbesondere eine Schaltungsanordnung für einen vorzugsweise rauscharmen linearen Eingangsverstärker. Solche Eingangsverstärker sind bevorzugt für Quellen mit definiertem Generatorwiderstand, die hohe Anforderungen an die Rauschzahl, die Linearität und die Verstärkung haben, geeignet.

### Stand der Technik

Quellen mit definierter Ausgangsspannung oder Generatorspannung sind beispielsweise Keramik- oder Quarzfilter, die für eine bestimmte Frequenz ausgelegt sind und als Bandpassfilter arbeiten. Diese Frequenz kann beispielsweise bei 10.7 MHz liegen. Damit man bei einem solchen Beispiel eine spezifizierte Bandpass-Übertragungsfunktion erhält, muss in der Regel der Eingangswiderstand des Eingangsverstärkers an den Ausgangswiderstand des Filters angepasst werden. In der Regel wird weiterhin eine sogenannte Leistungsanpassung durchgeführt, das heißt, dass der Eingangswiderstand gleich dem Generatorwiderstand ist. Der Generatorwiderstand muss aber nicht unbedingt der Ausgangswiderstand eines Filters sein, sondern kann auch der Widerstand oder eine Impedanz beispielsweise einer Antenne sein.

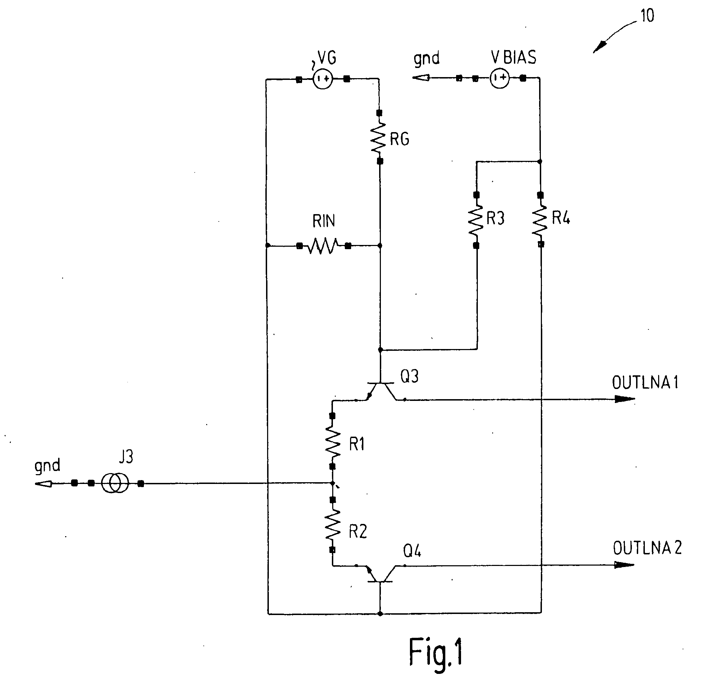

In Figur 1 ist eine Schaltungsanordnung eines Differenzverstärkers 10 mit Widerstandsgegenkopplung dargestellt. Diese Schaltungsanordnung wird häufig als Eingangsverstärker verwendet. Der definierte Eingangswiderstand der Schaltungsanordnung wird durch RIN realisiert mit (RIN << R3 + R4). Die Verstärkung und die Linearität werden durch die Widerstände R1 und R2 und durch die Größe des Stroms 13 bestimmt. Die Linearität steigt mit dem Wert von 13, R1 und R2. Im Stand der Technik wird diese Schaltung auch als Emitterschaltung mit Stromgegenkopplung bezeichnet. Die Übertragungsfünktion der Anordnung I(OUTLNA1)/VG ist für R1=R2=0 eine Tangenshyperbolikusfünktion aufgrund der sich bei einer Ansteuerung ändernden Basis-Emitterspannung. Der Nachteil der Schaltung liegt darin, dass RIN einen Teil der verfügbaren Leistung der Quelle VG verbraucht und damit zu einer erheblichen Verschlechterung der Rauschzahl beiträgt.

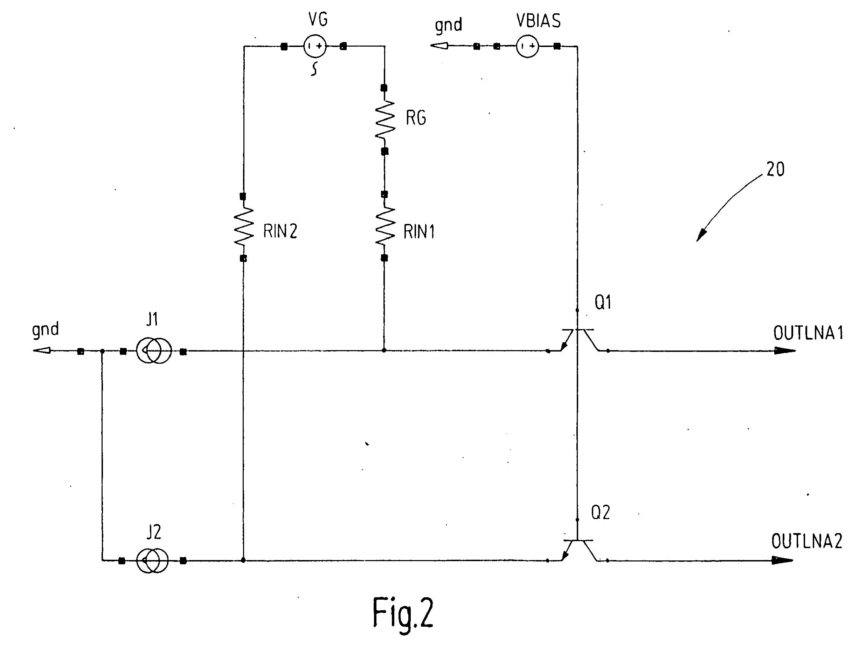

Die Figur 2 zeigt weiterhin eine Schaltung 20 nach dem Stand der Technik, bei welcher eine sogenannte Basisschaltung oder auch Common-Base-Schaltung realisiert ist, die als Eingangsverstärkerschaltung verwendet wird. Der definierte Eingangswiderstand wird durch die Summe von RIN1 und RIN2 und dem Eingangswiderstand von Q1 mit re1= UT/I1 und Q2 mit re2 = UT/I2 vorgegeben, so dass sich ergibt: RIN = RIN1 + RIN2 + UT/I1 + UT/12. Dabei wird die Linearität mit dem zunehmenden Wert der Eingangswiderstände RIN1 und RIN2 und der Ströme 11 und 12 größer. Die Schaltung gemäß Figur 2 hat eine bessere Rauschzahl als die Schaltung von Figur 1, weil die zur Realisierung eines definierten Eingangswiderstands verwendeten Widerstände RNI1 und RIN2 gleichzeitig zur Linearisierung der Transistorübertragungsfunktionen von Q1 und Q2 beitragen. Sie haben dabei eine vergleichbare Funktion wie die beiden Widerstände R1 und R2 bei der Schaltung gemäß Figur 1. Der Nachteil der Schaltung gemäß Figur 2 ist die durch den Generatorwiderstand und den Eingangwiderstand festgelegte Verstärkung, die für die Schaltung gemäß Figur 2 gegeben ist durch I(OUTLNA1) / VG = 1/(RG + RIN1 + RIN2 + re1 + re2) = 1 / (RG + RIN) = ½ RG mit RG = RIN. Dies bedeutet, dass mit einer Erhöhung von I1 und 12 mit re1,re2 << RIN1,RIN2 zwar eine Verbesserung der Linearität erreicht werden kann, es kann aber nur eine sehr geringe Vergrößerung der Verstärkung erzielt werden. Dies ist insbesondere nachteilig, wenn die nachfolgenden Schaltungen stark rauschen und aufgrund einer geringen Eingangsverstärkung einen erhöhten Beitrag zum Gesamtrauschen liefern.

Eine weitere mögliche Schaltungsanordnung sind rückgekoppelte Operationsverstärker. Sie neigen aber oft zum Schwingen und zu nichtlinearem Verhalten bei hohen Eingangsfrequenzen.

Die US 6504403 B2 offenbart eine Niederspannungs-Differential-Signalschaltung, bei welcher zweite Verstärkerschaltungen verwendet werden, die in einem ersten und einem zweiten Unterbereich arbeiten. Dabei wird der Ausgang der Common-Base-Stufe über den D-Verstärker mit dem Ausgang der Common-Emitter-Stufe addiert. Diese beiden haben keine Gegenkopplungsimpedanz in den Emitterzweigen. Eine entsprechende Linearisierung der Transistorübertragungsfunktion über einen großen Eingangsspannungsbereich ist somit nicht möglich.

Die US 2005/0068106 A1 offenbart eine rauscharme Verstärkungsschaltung, bei der ein schaltbares Verstärkungsverhältnis realisiert ist, wobei für kleine Verstärkungen ein anderer Strompfad aktiv ist als für große Verstärkungen, wobei zwischen diesen Pfaden umgeschaltet wird.

WO 03/005566 A2 zeigt eine rauscharme Verstärkerschaltung mit einem ersten Strompfad, der einen Transistor in Basisschaltung umfasst, und einen zweiten Strompfad, der einen Transistor in Emitterschaltung umfasst, wobei dem Transistor in Emitterschaltung ein weiterer Transistor in Basisschaltung nachgeschaltet ist, und einer Umschalteinrichtung zum Aktivieren des ersten oder als zweiten Strompfads in Abhängigkeit von einer gewünschten Verstärkung.

EP 0 893 880 A1 zeigt eine Verstärkerstufe mit einem ersten und einem zweiten Differenzverstärkerzweig und einem ersten und einem zweiten impedanzbehafteten Zweig, wobei der erste impedanzbehaftete Zweig parallel zur Eingangsimpedanz des ersten und der zweite impedanzbehaftete Zweig parallel zur Eingangsimpedanz des zweiten Differenzverstärkerzweigs geschaltet ist, um die Verstärkerparameter weitgehend konstant zu halten.

### Darstellung der Erfindung. Aufgabe, Lösung. Vorteile

Die Aufgabe der Erfindung ist es, eine Schaltungsanordnung zu schaffen, die bei gefordertem Eingangswiderstand eine geringere Rauschzahl und eine bessere Linearität und Verstärkung als die im Stand der Technik bekannten Anordnungen hat. Dabei ist es weiterhin vorteilhaft, wenn die erfindungsgemäße Schaltung weitaus stabiler bzw. robuster ist als eine rückgekoppelte Anordnung, wie beispielsweise ein rückgekoppelter Operationsverstärker.

Die Aufgabe wird gelöst durch eine Schaltungsanordnung gemäß Anspruch 1.

Vorteilhafte Weiterbildungen sind in den Unteransprüchen beschrieben.

### Kurze Beschreibung der Zeichnungen

Nachstehend wird die Erfindung auf der Grundlage eines Ausfühnmgsbeispiels anhand der Zeichnungen näher erläutert. Es zeigen:
- Fig. 1: eine schematische Darstellung einer Emitterschaltung mit Stromgegenkopplung gemäß dem Stand der Technik;
- Fig. 2: eine Common-Base-Schaltung nach dem Stand der Technik;
- Fig. 3: eine erfindungsgemäße Schaltung;
- Fig. 4: eine erfmdungsgemäße Schaltung;
- Fig. 5: eine Darstellung eines Diagramms;
- Fig. 6: eine Darstellung eines Diagramms;
- Fig. 7: eine erfindungsgemäße Schaltung;
- Fig. 8: eine erfindungsgemäße Schaltung; und
- Fig. 9: eine erfindungsgemäße Schaltung;

### Bevorzugte Ausführung der Erfindung

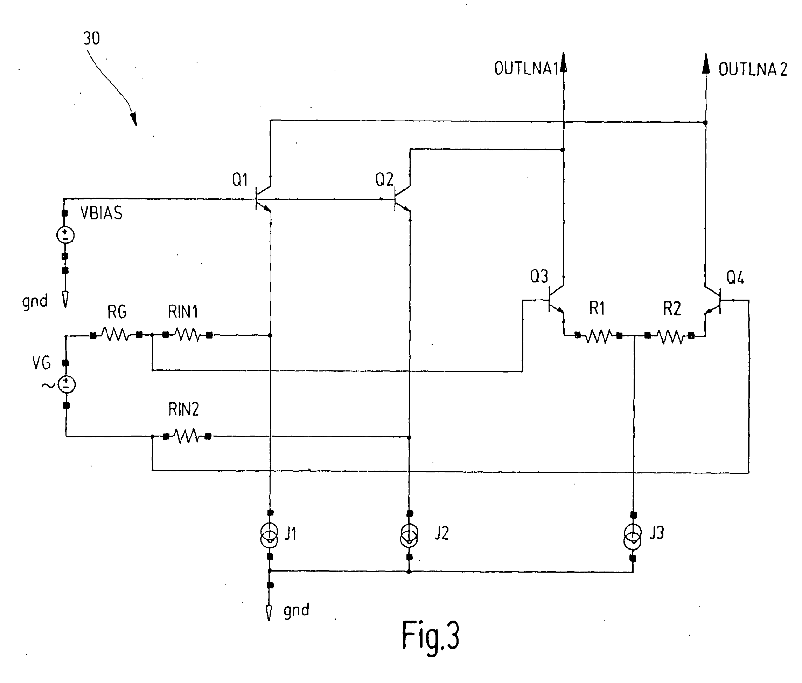

Die Figur 3 zeigt eine erfindungsgemäße Schaltungsanordnung 30, die sich dadurch auszeichnet, dass sie eine spezielle Kombination, wie eine Parallelschaltung, einer Emitterschaltung und einer Basisschaltung der beiden Schaltungen 10,20 nach Figur 1 und nach Figur 2 ist. Die Schaltung 30 verbindet die Vorteile beider Schaltungen 10 und 20. Darüber hinaus bietet sie zusätzlich die Möglichkeit einer vollständigen Linearisierung der Transistorübertragungsfunktionen, wie Tangenshyperbolikusfunktion tanh, von Q1, Q2, Q3 und Q4 bei entsprechender Dimensionierung der Ströme und Widerstände der Schaltung über einen großen Eingangsspannungsbereich. Die Schaltung nach Figur 3 zeigt in einem Bereich, dass die Kollektoren der beiden Transistorpaare Q1, Q4 und Q2, Q3 jeweils ausgangsseitig gekoppelt sind. Die beiden emittergekoppelten Transistoren sind über die Widerstände R1 und R2 gekoppelt, wobei die Widerstände an ihrem anderen Anschlußpol an der Stromquelle 13 angeschlossen sind. Die Basis von Transistor Q3 und Transistor Q4 ist jeweils mit einem der Eingangswiderstände RINI1 und RIN2 gekoppelt, wobei die Basis von Q3 zwischen RG und RIN1 gekoppelt ist. Gleichzeitig sind die Emitter von Q1 und Q2 ebenfalls mit RIN1 und RIN2 gekoppelt. Die Basis von Q1 und von Q2 ist jeweils miteinander gekoppelt und liegen an der Versorgungsspannung VBIAS an.

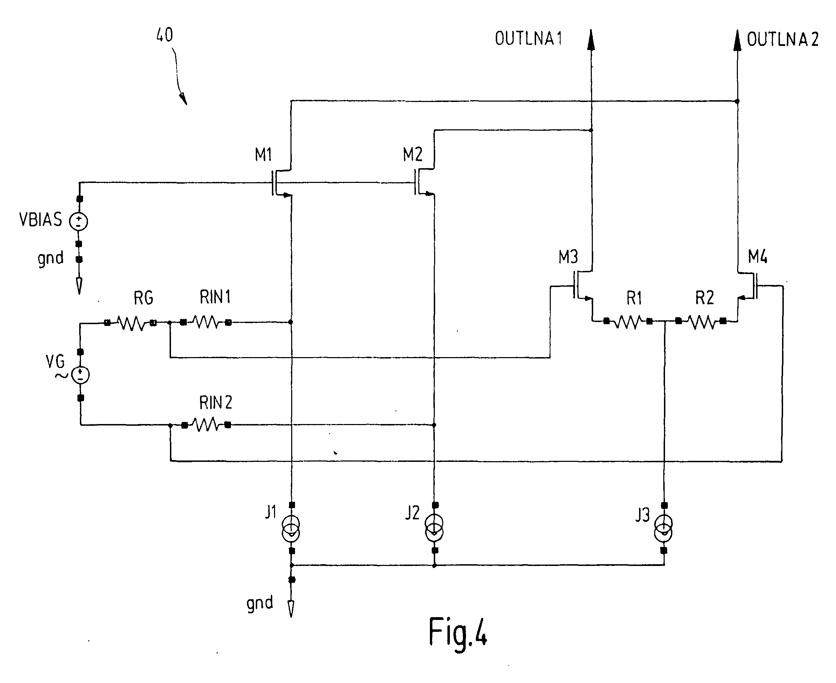

Die Figur 4 zeigt dem gegenüber eine Schaltung 40, in welcher statt der Bipolar-Transistoren Qi der Figur 3 Feldeffekttransistoren Mi verwendet werden. Ansonsten arbeitet die Schaltung 40 der Figur 4 entsprechend der Funktion der Schaltung 30 der Figur 3.

Der geforderte Eingangswiderstand wird mit RIN1, RIN2 und den Innenwiderständen der Transistoren Q1 und Q2 (rel=UT/I1, re2=UT1/12) realisiert. Gleichzeitig trägt diese Schaltung am Ausgang zu einem Teil der Gesamtleistungsverstärkung bei. Die Schaltung ersetzt quasi den Widerstand RIN in Fig. 1, der letztendlich nur verfügbare Leistung vernichtet und dazu noch rauscht. Um eine höhere Verstärkung zu erzielen, ist der Differenzverstärker (Q3, Q4, R1, R2, 13) parallelgeschaltet. Der Eingangswiderstand wird durch ihn nur vernachlässigbar reduziert, weil seine Eingangsimpedanz sehr hochohmig ist. Die Addition der Ausgangsströme (Kollektoren Q1, Q2, Q3 und Q4) erfolgt vorzeichenrichtig nach Fig. 3.

Der Wechselstrom, der aus den Terminals OUTLNA1 und OUTLNA2 heraus fließt, beinhaltet nichtlineare Komponenten aufgrund der tanh-Funktion der Transistorkennlinien. Diese Komponenten, die von der Änderung der Basis-Emitterspannung UBE der Transistoren herrühren, können bei einer bestimmten Dimensionierung der Ströme und Widerstände der Schaltung nach Fig. 3 bzw. nach Figur 4 in hohem Masse reduziert werden.

Diesen Mechanismus kann man qualitativ wie folgt erklären. Wird die Spannung VG von Plus nach Minus größer, fließt ein Strom über RG und RIN1 in den Emitter von Q1 hinein und über R1N2 aus dem Emitter von Q2 heraus. Dadurch verkleinert sich das UBE von Q1. Im gleichen Maße vergrößert sich das UBE von Q2. Gleichzeitig wird die Spannung an der Basis von Q3 angehoben, und die Spannung an der Basis von Q4 abgesenkt. Damit vergrößert sich der Kollektorstrom und das UBE von Q3 und im gleichen Masse verkleinert sich Kollektorstrom und UBE von Q4. Macht man einen Maschenspannungsumlauf von der Basis Q3 -> Emitter Q3 -> R1 -> R2 -> Emitter Q4 - > Basis Q4 -> RIN2 -> Emitter Q2 -> Basis Q2 -> BasisQ1 -> Emitter Q1 -> RJN1 -> Basis Q3 dann erscheinen in der Gleichung die Terme der Änderung von UBE1 und UBE3 bzw. UBE2 und UBE4 mit umgekehrten Vorzeichen. Dimensioniert man also die Ströme und Widerstände der Schaltung der Anordnung so, dass die Änderung von UBE1 gleich der Änderung von UBE3 und die Änderung von UBE2 gleich der Änderung von UBE4 ist, dann sind die nichtlinearen Komponenten in den Ausgangsströmen aus den Terminals OUTLNA1 und OUTLNA2 in hohem Masse reduziert.

Vorteilhaft kann zur Findung von Lösungen die folgende Vorgehensweise gewählt werden. Der Generatorwiderstand RG ist gegeben. Man wählt einen dazu optimalen Wert für den Eingangswiderstand, beispielsweise RIN=RG, und dimensioniert die Ströme 11 und 12 und RIN1 und RIN2 so, dass der gewünschte Wert erreicht wird. R1, R2 und 13 findet man beispielsweise durch "iteratives simulieren" mittels eines Simulators.

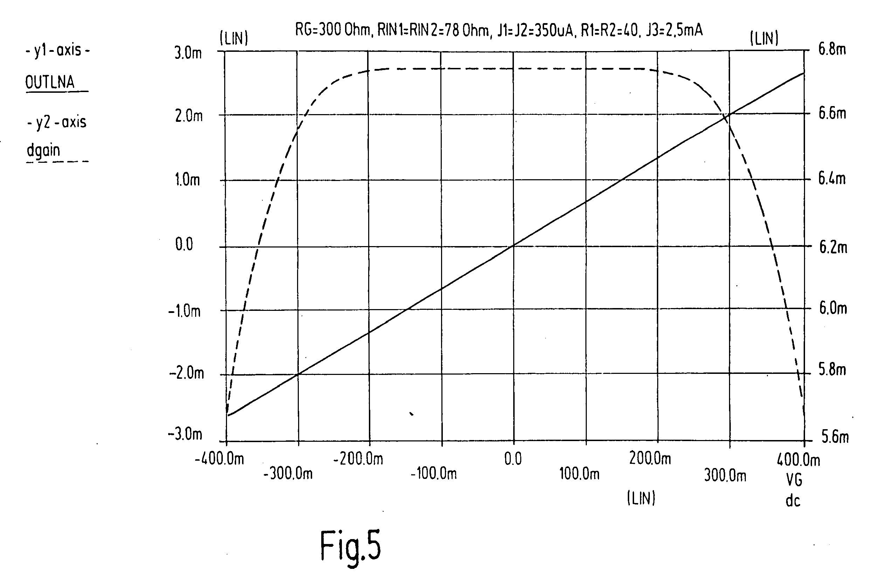

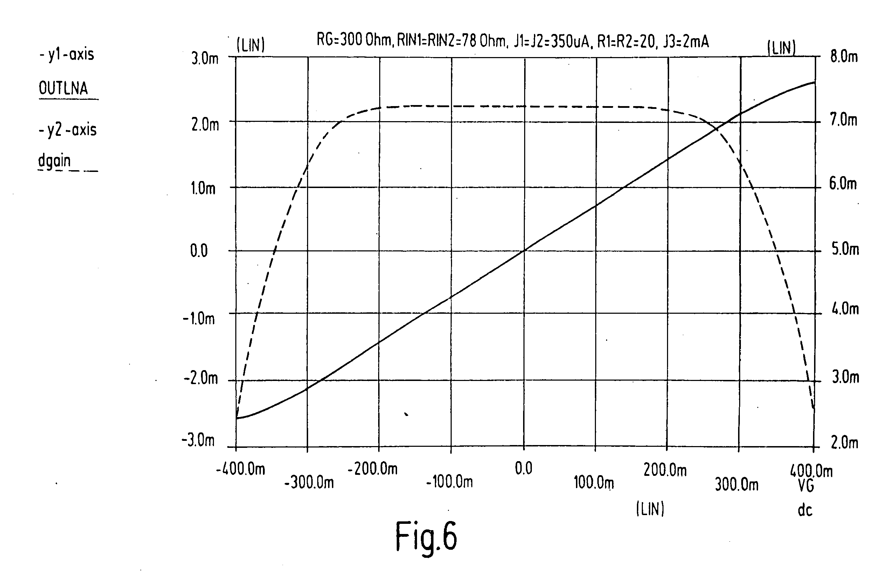

Die Figur 5 und die Figur 6 zeigen Diagramme mit möglichen Lösungen für RG=300 Ohm. Die Figuren 5 und 6 zeigen jeweils Kurven dgain und OUTLNA als Funktion von VG. Die Kurve dgain ist dabei die Ableitung dOUTLNA/dVG. In dem Bereich, in dem dgain konstant ist, ist die Übertragungsfunktion OUTLNA=OUTLNA1-OUTLNA2 sehr linear. Die Widerstände RIN1, RIN2, R1 und R2 können auch den Wert Null annehmen. In diesem Fall ist die Größe der Aussteuerbarkeit am geringsten.

Die Linearisierung ist auch mit Feldeffekt(MOS)-Transistoren realisierbar, siehe Fig. 4. Die Werte der Widerstände und Ströme bei einer Schaltung nach Figur 4 sind dann allerdings verschieden von den Werten bei einer Schaltung nach Fig. 3, da MOS-Transistoren Mi sich mathematisch unterschiedlich verhalten als Bipolar-Transistoren Qi.

Die Diagramme der beiden Figuren 5 und 6 unterscheiden sich auch dadurch voneinander, dass in Figur 5 die Kurven berechnet wurden nach dem Beispiel der Figur 3, wobei die Widerstände R1 und R2 mit 20 Ohm kleiner als bei dem Beispiel der Figur 6 mit 40 Ohm sind. Auch ist dabei 13 mit 2,0 mA bzw. 2,5 mA unterschiedlich gewählt.

Dabei ist weiterhin Rg mit 300 Ohm als Beispiel angenommen. Weiterhin ist bei Figur 5 11 und 12 vorgegeben. Mit RIN=RG ergeben sich RIN1 und RIN2. Es kann auch RIN1 und RIN2 vorgeben werden und I1,2 kann daraus berechnet werden. Danach ist R1 und R2 vorgegeben worden und der Strom 13 wurde so lange variiert, bis die Ausgangsfunktion linear ist. Bei einem weiteren Ausführungsbeispiel kann auch 13. vorgegeben werden und anschließend R1,2 variiert werden.

Für vorgegebene Werte von I1,2 und RIN1,2 und Rg findet man so immer eine Lösung für R1,2 und I3. Es kann allerdings auch sein, dass für vorgegebene Werte RG, RIN1,2 und R 1,2 der Strom 13 zur Linearisierung unverhältnismäßig groß wird. Dann können die Vorgaben jedoch geändert werden.

In Figur 6 sind im Vergleich zur Figur 5 R,2 auf 200hm gesetzt, um eine größere Verstärkung zu erreichen. Der Strom 13 simuliert sich dann zu 2mA

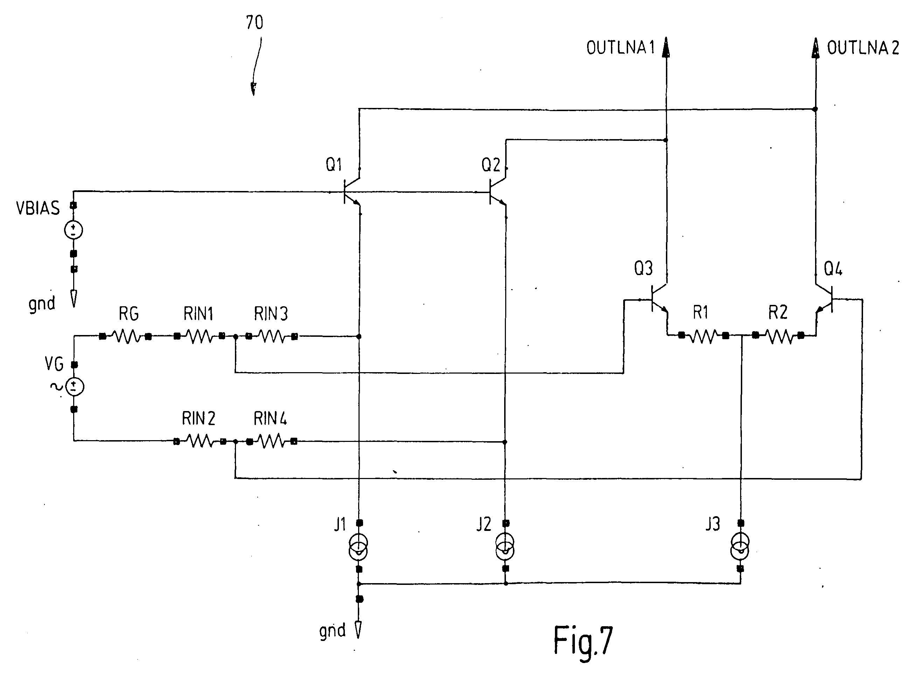

Die Figur 7 zeigt ein weiteres vorteilhaftes Ausführungsbeispiel der Erfindung. Dabei werden in der Schaltung 70 gemäß Figur 7 die Widerstände RIN1 und RIN2, wie sie in der Figur 3 verwendet werden, durch Widerstände RIN1+RIN3 bzw. RIN2+RIN4 ersetzt und die Basen von den Transistoren Q3 und Q4 entsprechend Figur 7 zwischen den beiden Widerständen RIN1,RIN3 bzw. RIN2,RIN4 angeschlossen.

Entsprechend dem Beispiel der Figur 5, könnten die Widerstände RIN1 und RIN3 (und RIN2 und RIN4) beispielsweise zu jeweils 39 Ohm gewählt werden. Die Werte für R1, R2 und 13 werden dann aber andere als die in Figur 5 sein. Es lässt sich aber in jedem Fall eine Lösung für einen linearisierten Ausgangsstrom finden. Die kleinste Rauschzahl erhält man für die Anordnung nach Figur 3, eine dazu etwas ungünstigere Rauschzahl nach Fig. 7 mit R1N3=RIN4=O und RIN1,2(Fig. 7)=RIN1,2(Fig. 3). Allerdings können auch Zwischenwerte erreicht werden.

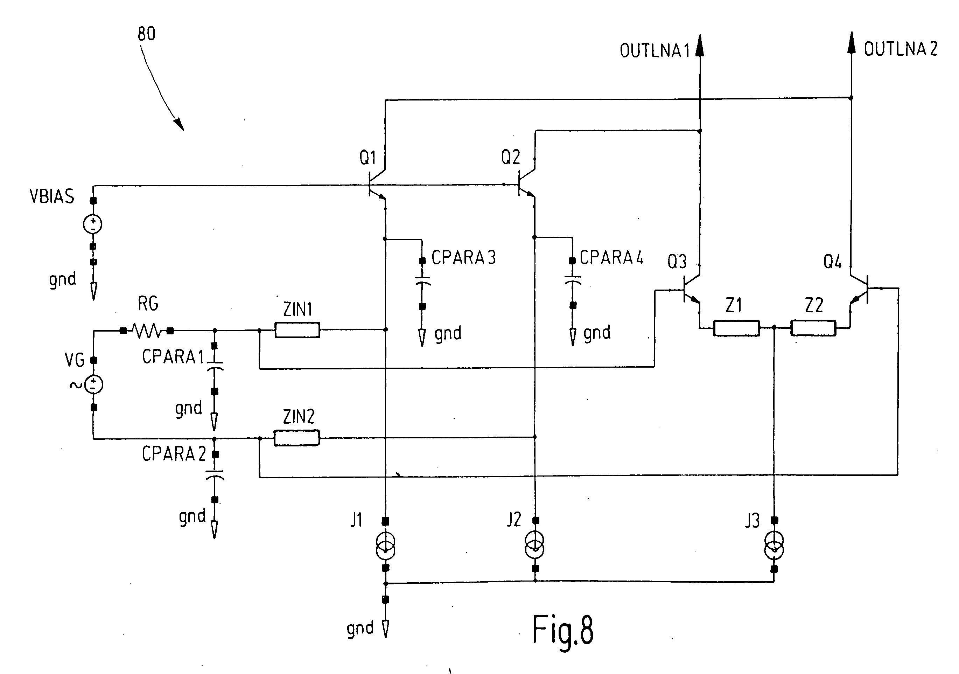

Figur 8 zeigt weiterhin eine allgemeine Ausführung einer Schaltung 80 gemäß Erfindung, so wie sie beispielsweise für sehr hohe Eingangsfrequenzen beispielsweise im Gigaherzbereich realisiert wird. In diesem Fall gehen die parasitären Kapazitäten der Bondpads und die kapazitive Eingangsimpedanz CPARA1,2 von Q3 und Q4 und die parasitären Kapazitäten CPARA 3,4 von Q1, Q2 und der Stromquellen I1 und I3 ein. Um eine reale Eingangsimpedanz zu erhalten, sind die Impedanzen ZIN1,2 und Z1,2 vorteilhaft eine Serienschaltung aus Widerstand und Spule, um den kapazitiven Anteil zu kompensieren. Entsprechend sind parasitäre Impedanzen CPARA1,2,3,4 in der Schaltung 80 berücksichtigt. Die parasitären Impedanzen sind gegen Masse gnd dargestellt.

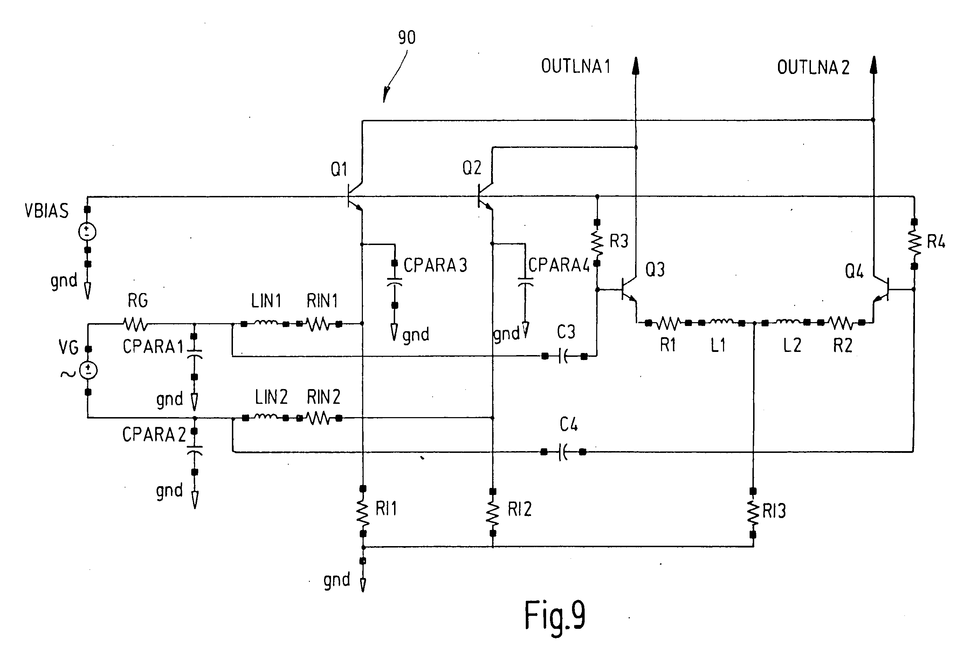

Die Figur 9 zeigt weiterhin eine erfindungsgemäße Ausführung einer Schaltung 90. Die Basen von Q3 und Q4 sind über einen Hochpass R3, C3 bzw. R4, C4 mit einer Grenzfrequenz weitaus kleiner als die Empfangsfrequenz an den Eingang und die Spannung VBIAS gekoppelt. Die Emitterspannung von Q3 und Q4 liegen in diesem Fall nur etwa ein UBE (etwa 850 mV) unter VBIAS. In den Schaltungen gemäß der Figuren 3, 7 und 8 liegt diese Spannung zwei UBE unter VBIAS. Für kleine Versorgungsspannungen verhält sich die Anordnung nach Figur 9 besser. Die Impedanzen ZIN1,2 und Z1,2 der Figur 8 sind in Figur 9 durch Widerstände und Spulen LIN1, LIN2, L1, L2 ersetzt, die Ströme 11,2,3 durch die Widerstände RI1,2,3 ersetzt.

In den Figuren 7,8 und 9 kann man die Bipolar-Transistoren auch durch FeldeffektTransistoren ersetzen und durch entsprechende Dimensionierung der Impedanzen Z1, Z2 und des Stromes I3. mittels eines Simulators eine in hohem Masse Linearisierung des Ausgangsstromes erreichen.

Die Erfindung ermöglicht es somit, rauscharme, lineare Vorstufen mit geringer Stromaufnahme für kleine Versorgungsspannungen zu realisieren. Da sie aus einfachen Schaltungsanordnungen besteht, ist sie sehr robust und braucht als Chip nur wenig Chipfläche.

Die erfindungsgemäßen Schaltungen können vorteilhaft bei analogen Empfängern für digitale Signale verwendet werden, wie beispielsweise bei 2.3 GHz, wie die Anordnung nach Figur 9, oder bei 250MHz entsprechend einer Anordnung nach Figur 9 ohne Spulen oder Figur 3. Für beide Frequenzen können externe Zwischenfrequenz (IF) - Filter verwendet werden, welches den notwendigen Generatorwiderstand bereitstellt. Vorteilhaft sind die Schaltungen in integrierte Schaltungen (IC) integriert.

### BEZUGSZEICHENLISTE

- 10: Schaltung
- 20: Schaltung
- 30: Schaltung
- 40: Schaltung
- 70: Schaltung
- 80: Schaltung
- 90: Schaltung
- und: Masse
- VG: Generatorspannung
- VBIAS: Versorgungsspannung
- RG: Generatorwiderstand
- RIN: Eingangswiderstand
- RIN1: Eingangswiderstand
- RIN2: Eingangswiderstand
- RIN3: Eingangswiderstand
- RIN4: Eingangswiderstand
- R1: Widerstand
- R2: Widerstand
- R3: Widerstand
- R4: Widerstand
- Q1: Transistor
- Q2: Transistor
- Q3: Transistor
- Q4: Transistor
- M1: MOS-Transistor
- M2: MOS-Transistor
- M3: MOS-Transistor
- M4: MOS-Transistor
- I1: Strom
- I2: Strom
- 13: Strom
- OUTLNA1: Ausgangsspannung
- OUTLNA2: Ausgangsspannung
- CPARA1: parasitäre Kapazität
- CPARA2: parasitäre Kapazität
- CPARA3: parasitäre Kapazität
- CPARA4: parasitäre Kapazität
- Z1: Impedanz
- Z2: Impedanz
- ZIN 1: Eingangsimpedanz
- ZIN2: Eingangsimpedanz
- LIN1: Eingangsspule
- LIN2: Eingangsspule
- L1: Spule
- L2: Spule
- RI1: Widerstand
- RI2: Widerstand
- RI3: Widerstand

## Patentansprüche

1. Schaltungsanordnung (30,40,70,80,90) eines rauscharmen linearen Eingangsverstärkers mit einer Parallelschaltung einer Basisschaltung (20) und einer Emitterschaltung (30), wobei die Emitter zweier erster Transistoren (Q3,Q4) der Emitterschaltung (30) miteinander verkoppelt sind und die Basen zweier zweiter Transistoren (Q1,Q2) der Basisschaltung (20) miteinander gekoppelt sind, die Kollektoren parallel zum Ausgang verschaltet sind und die Quellenspannung (VG) mit den Emittern der zweiten Transistoren (Q1,Q2) und mit den Basen der ersten Transistoren (Q3,Q4) verkoppelt ist, **dadurch gekennzeichnet,**
**dass** eine Linearisierung des Ausgangsstromes (OUTLNA1,2) als Funktion der Quellenspannung (VG) durch eine Linearisierung der Übertragungsfunktion, wie beispielsweise Tangenshyperbolikusfunktion, der ersten und zweiten Transistoren (Q1,Q2,Q3,Q4) erreicht ist,
wobei die Linearisierung derart erfolgt, dass die Schaltungselemente derart dimensioniert sind, dass die Basis-Emitterspannungen der Transistoren derart gewählt sind, dass die Änderung der Basis-Emitterspannung eines ersten Transistors (Q3,Q4) gleich der Änderung der Basis-Emitterspannung eines zweiten Transistors (Q1,Q2) ist.

2. Schaltungsanordnung nach Anspruch 1, **dadurch gekennzeichnet, dass** die Linearisierung der Übertragungsfunktion, wie beispielsweise Tangenshyperbolikusfunktion, der ersten und zweiten Transistoren durch die Dimensionierung der Ströme, Widerstände ,Impedanzen, Kapazitäten und/oder Spulen der Schaltung erreicht ist.

3. Schaltungsanordnung nach einem der vorhergehenden Ansprüche, **dadurch gekennzeichnet, dass** der Eingangswiderstand durch die Vorgabe von den Widerständen (RIN1,RIN2) und Innenwiderständen (re1 = UT/I1 und re2 = UT/12) der Transistoren (Q1,Q2) vorgegeben wird.

4. Schaltungsanordnung nach einem der vorhergehenden Ansprüche, **dadurch gekennzeichnet, dass** die Transistoren Bipolar-Transistoren oder MOS-Transistoren, wie Feldeffekttransistoren, sind.

5. Schaltungsanordnung nach einem der vorhergehenden Ansprüche, **dadurch gekennzeichnet, dass** die Eingangswiderstände als Reihenschaltung von Widerständen realisiert sind.

6. Schaltungsanordnung nach einem der vorhergehenden Ansprüche, **dadurch gekennzeichnet, dass** die Eingangswiderstände und/oder Widerstände als Impedanzen realisiert sind.

7. Schaltungsanordnung nach einem der vorhergehenden Ansprüche, **dadurch gekennzeichnet, dass** die Eingangswiderstände und/oder Widerstände als Widerstands-Spulen-Schaltungen realisiert sind.

8. Schaltungsanordnung nach einem der vorhergehenden Ansprüche, **dadurch gekennzeichnet, dass** weiterhin parasitäre Kapazitäten durch die Wahl der Impedanzen oder durch zusätzliche Kapazitäten berücksichtigt werden.

## Claims

1. A circuit array (30, 40, 70, 80, 90) of a low-noise linear input amplifier having a parallel connection of a common base connection (20) and a common emitter connection (30), wherein the emitters of two first transistors (Q3, Q4) of the common emitter connection (30) are coupled with each other and the bases of two second transistors (Q1, Q2) of the common base connection (20) are coupled with each other, wherein the collectors are connected parallel to the output, and wherein the source voltage (VG) is coupled with the emitters of the second transistors (Q1, Q2) and with the bases of the first transistors (Q3, Q4),
**characterized in that**
a linearization of the output current (OUTLNA1,2), as function of the source voltage (VG), is accomplished by a linearization of the transfer function, as for example tangens hyperbolicus function, of the first and second transistors (Q1, Q2, Q3, Q4),
wherein the linearization is carried out in such a way that the circuit elements are dimensioned in such a way that the base-emitter voltages of the transistors are selected in such a way that the change of the basis-emitter voltage of a first transistor (Q3, Q4) is equal to the change of the base-emitter voltage of a second transistor (Q1, Q2).

2. The circuit array according to claim 1, **characterized in that** the linearization of the transfer function, as for example tangens hyperbolicus function, of the first and second transistors is accomplished by dimensioning the currents, resistors, impedances, capacitances and/or coils of the circuit.

3. The circuit array according to one of the preceding claims, **characterized in that** the input resistor is predetermined by specifying of the resistors (RIN1, RIN2) and internal resistances (re1 = UT/I1 and re2 = UT/I2) of the transistors (Q1, Q2).

4. The circuit array according to one of the preceding claims, **characterized in that** the transistors are bipolar-transistors or MOS-transistors, such as field effect transistors.

5. The circuit array according to one of the preceding claims, **characterized in that** the input resistors are implemented as series connection of resistors.

6. The circuit array according to one of the preceding claims, **characterized in that** the input resistors and/or resistors are implemented as impedances.

7. The circuit array according to one of the preceding claims, **characterized in that** the input resistors and/or resistors are implemented as resistors-coil circuits.

8. The circuit array according to one of the preceding claims, **characterized in that** parasitic capacitances are further taken into account by the choice of the impedances or by additional capacitances.

## Revendications

1. Circuit (30, 40, 70, 80, 90) d'un amplificateur d'entrée linéaire à faible bruit, ayant un montage en parallèle d'un circuit de base (20) et d'un circuit d'émetteur (30), les émetteurs des deux premiers transistors (Q3, Q4) du circuit d'émetteur (30) étant couplés ensemble et les bases des deux deuxièmes transistors (Q1, Q2) du circuit de base (20) étant couplées ensemble, les collecteurs étant montés en parallèle à la sortie et la tension de source (VG) étant couplée avec les émetteurs des deuxièmes transistors (Q1, Q2) et avec les bases des premiers transistors (Q3, Q4),
**caractérisé en ce que**,
une linéarisation du courant de sortie (OUTLNA1,2) en fonction de la tension de source (VG) est obtenue par une linéarisation de la fonction de transfert, telle que par exemple une fonction tangente hyperbolique, des premiers et deuxièmes transistors (Q1, Q2, Q3, Q4),
la linéarisation étant effectuée d'une manière telle que les éléments du circuit soient dimensionnées d'une manière telle que les tensions base-émetteur des transistors soient choisies de manière telle que la variation de la tension base-émetteur d'un premier transistor (Q3, Q4) soit égale à la variation de la tension base-émetteur d'un deuxième transistor (Q1, Q2).

2. Circuit selon la revendication 1, **caractérisé en ce que** la linéarisation de la fonction de transfert, telle que par exemple une fonction tangente hyperbolique, des premiers et deuxièmes transistors est obtenue par le dimensionnement des courants, résistances, impédances, capacités et/ou inductances du circuit.

3. Circuit selon l'une quelconque des revendications précédentes, **caractérisé en ce que** la résistance d'entrée est prédéfinie par la spécification des résistances (RIN1, RIN2) et des résistances internes (re1 = UT/I1 et re2 = UT/12) des transistors (Q1, Q2).

4. Circuit selon l'une quelconque des revendications précédentes, **caractérisé en ce que** les transistors sont des transistors bipolaires ou des transistors MOS, tels que des transistors à effet de champ.

5. Circuit selon l'une quelconque des revendications précédentes, **caractérisé en ce que** les résistances d'entrée sont réalisées par le montage en série de résistances.

6. Circuit selon l'une quelconque des revendications précédentes, **caractérisé en ce que** les résistances d'entrée et/ou les résistances sont réalisées sous forme d'impédances.

7. Circuit selon l'une quelconque des revendications précédentes, **caractérisé en ce que** les résistances d'entrée et/ou les résistances sont réalisées sous forme de circuits de résistances et de bobines.

8. Circuit selon l'une quelconque des revendications précédentes, **caractérisé en ce qu'**il est tenu compte par ailleurs de capacités parasites par le choix des impédances ou par des capacités supplémentaires.
